# EUROPÄISCHE PATENTSCHRIFT

(11) **EP 4 643 616 B1**
(45) Veröffentlichungstag und Bekanntmachung des Hinweises auf die Patenterteilung: **07.10.2026**
(21) Anmeldenummer: 24702263.5
(22) Anmeldetag: 19.01.2024
(51) Int. Cl.: H05K 7/20, H02M 5/00, H02M 7/00

(54) **UMRICHTER MIT VERBESSERTER KÜHLUNG UND UMRICHTERSCHRANK**
CONVERTER WITH IMPROVED COOLING AND CONVERTER CABINET
CONVERTISSEUR À REFROIDISSEMENT AMÉLIORÉ ET ARMOIRE DE CONVERTISSEUR

(30) Priorität: 03.03.2023 EP 23159978
(43) Veröffentlichungstag der Anmeldung: 05.11.2025
(73) Patentinhaber: Siemens Aktiengesellschaft, 80333 München (DE)
(72) Erfinder: FLEISCH, Karl, 91054 Erlangen (DE); MÜLLER, Volker, 90459 Nürnberg (DE)
(74) Vertreter: Siemens Patent Attorneys
(86) Internationale Anmeldenummer: PCT/EP2024/051258
(87) Internationale Veröffentlichungsnummer: WO 2024/183977

(56) Entgegenhaltungen:
- EP-A1- 2 996 449
- DE-A1- 102015 215 570
- JP-A- H08 186 388
- US-A1- 2020 244 178

## Beschreibung

Die Erfindung betrifft einen Umrichter mit verbesserter Kühlung und einen Umrichterschrank mit einem solchen Umrichter.

Aus der Patentanmeldung CN 107733242 A ist ein wassergekühlter Umrichter bekannt. Das Wasserkühlsystem des Umrichters ist mit einem Wärmetauscher verbunden, durch den die Abwärme des Umrichters abgeführt wird. Das Wasserkühlsystem umfasst drei Sub-Kühlsysteme, die jeweils mit einem IGBT-Arm des Umrichters verbunden sind.

Die Europäische Patentanmeldung EP 0 677 916 A2 offenbart eine Stromrichteranlage mit luftgekühlten Leistungshalbleitern und Gleichspannungszwischenkreis. Die Leistungshalbleiter sind auf den Hauptoberflächen einer Kühlschiene angeordnet, die benachbart zu zwei Teil-Kondensatorbatterien angeordnet ist. In der Kühlschiene ist eine Vielzahl an Kühlkanälen ausgebildet.

Die Anmeldung US 2020/244178 A1 offenbart einen gekühlten Umrichter, der eine Kühlplatte umfasst, die beidseitig mit Siliziumcarbid-Halbbrücken besetzt ist. Die Kühlplatte ist wassergekühlt. Der Umrichter umfasst weiter einen Lüfter.

Die Druckschrift JP H08 186338 A zeigt eine Kühlvorrichtung für eine Leistungselektronikbaugruppe, die einen Lüfter aufweist. Die Leistungselektronikbaugruppe ist in einem Gehäuse aufgenommen, dem über den Lüfter Kühlluft zugeführt wird, so dass die Kühlluft zwischen Kühlfinnen der Leistungselektronikbaugruppe geführt wird. Die Kühlfinnen sind auf einer Seite eines Kühlkörpers ausgebildet. Auf einer den Kühlfinnen gegenüberliegenden Seite des Kühlkörpers sind Leistungselektronikkomponenten angeordnet.

Aus der Patentanmeldung DE 10 2015 215 570 A1 ist ein Kühlkörper für eine elektronische Vorrichtung bekannt, in dem ein Kühlkamin ausgebildet ist, der mit einem Kühlkanal verbunden ist. Der Kühlkanal und der Kühlkamin sind auf einer Seite ausgebildet, die der Seite mit elektronischen Komponenten gegenüberliegt.

Ferner zeigt das Dokument EP 2 996 449 A1 eine Stromrichteranordnung mit einem mehrphasigen Stromrichter, der für jede Stromrichterphase mehrere elektrisch miteinander verschaltete Stromrichtermodule umfasst. Die Stromrichteranordnung umfasst ebenso einen Stromrichterschrank, in dem der Stromrichter angeordnet ist.

Umrichter werden in einer Vielzahl industriellen Anwendungen und in der Energieversorgungstechnik eingesetzt, in denen steigende Anforderungen an deren elektrische Leistungsfähigkeit gestellt werden. Damit geht ein Bedarf an einer leistungsfähigeren Kühlung der Umrichter einher. Gleichzeitig werden eine einfache, kosteneffiziente Herstellung, Robustheit und Zuverlässigkeit gefordert. Der Erfindung liegt die Aufgabenstellung zugrunde, einen Umrichter bereitzustellen, der in zumindest einem der beschriebenen Aspekte eine Verbesserung bietet.

Die Aufgabenstellung wird durch einen erfindungsgemäßen Umrichter gelöst, der eine Mehrzahl an Halbleiterschaltern und zumindest einen Energiespeichern umfasst. Der Umrichter weist ebenso eine Zwischenkreisverschienung auf, über die zumindest einer der Halbleiterschalter mit dem zumindest einen Energiespeicher elektrisch verbunden ist. Der zumindest eine Energiespeicher kann als Kondensator ausgebildet sein. Zum Umrichter gehört auch ein erster Kühlkörper, durch den die Halbleiterschalter entwärmbar sind. Die Halbleiterschalter können beispielsweise als IGBTs ausgebildet sein. Dazu ist der erste Kühlkörper thermisch leitend mit den Halbleiterschaltern verbunden. Weiter weist der erfindungsgemäße Umrichter einen zweiten Kühlkörper auf, durch den die Energiespeicher entwärmbar sind. Hierzu ist der zumindest eine Energiespeicher, der beispielsweise als Kondensator ausgebildet sein kann, thermisch leitend mit dem zweiten Kühlkörper verbunden. Im Betrieb des Umrichters erfolgt eine im Wesentlichen unmittelbare Entwärmung der Halbleiterschalter in den ersten Kühlkörper und eine im Wesentlichen unmittelbare Entwärmung der Energiespeicher in den zweiten Kühlkörper. Der erste und zweite Kühlkörper sind jeweils flüssigkeitsgekühlt ausgebildet und mechanisch miteinander verbunden. Erfindungsgemäß sind der erste Kühlkörper und der zweite Kühlkörper entlang einer Aufbaurichtung des Umrichters zueinander versetzt angeordnet. Die Aufbaurichtung entspricht der Richtung, entlang der zumindest eine Halbleiterschalter auf den ersten Kühlkörper aufgesetzt ist und/oder der zumindest eine Energiespeicher auf den zweiten Kühlkörper aufgesetzt ist. Dadurch sind jeweils die Halbleiterschalter und der zumindest eine Energiespeicher unmittelbar an den ersten bzw. zweiten Kühlkörper entwärmbar. Die mechanische Verbindung zwischen dem ersten und zweiten Kühlkörper ist im Bereich eines Versatzes entlang der Aufbaurichtung ausgebildet. Durch den ersten und zweiten Kühlkörper, die versetzt zueinander angeordnet sind, ist erfindungsgemäß Umgebungsluft in einer Umgebung des Umrichters entwärmbar. Dadurch wird einem Erwärmen der Umgebungsluft, beispielsweise in einem zugehörigen Umrichterschrank, entgegengewirkt.

In einer Ausführungsform des beanspruchten Umrichters ist, entlang der Aufbaurichtung betrachtet, in einem Bereich zwischen dem ersten und zweiten Kühlkörper ein Erfassungsmittel angeordnet. Das Erfassungsmittel kann im Bereich einer Seite des ersten Kühlkörpers angeordnet sein, die den Halbleiterschaltern abgewandt ist. Das Erfassungsmittel kann als Strommessvorrichtung ausgebildet sein, die mit den Halbleiterschaltern elektrisch verbunden sein kann. Weiter kann das Erfassungsmittel mit einer Steuereinheit des Umrichters verbindbar sein. Der beanspruchte Umrichter bietet eine bauraumsparende Möglichkeit zur Montage des Erfassungsmittels.

In einer weiteren Ausführungsform des beanspruchten Umrichters sind der erste und zweite Kühlkörper zumindest im Bereich der Halbleiterschalter bzw. der Energiespeicher im Wesentlichen flächig ausgebildet. Die Kühlkörper sind dadurch jeweils in ihrem Wärmeleitverhalten im Wesentlichen als Scheiben beschreibbar. Weiter sind die im Wesentlichen flächigen Kühlkörper im Bereich des zumindest einen Energiespeichers bzw. der Halbleiterschalter flach ausgebildet. Dadurch ist eine großflächige thermische Kontaktierung zwischen dem zumindest einen Energiespeicher bzw. Halbleiterschaltern und dem jeweiligen Kühlkörper gewährleistet. Ferner bieten flächige Kühlkörper eine erhöhte Kühlleistung. Ferner können der erste und zweite Kühlkörper unabhängig voneinander hergestellt sein. Beispielsweise kann der erste Kühlkörper aus einem ersten Werkstoff und der zweite Kühlkörper aus einem zweiten Werkstoff hergestellt sein. Ferner kann der erste Kühlkörper mittels einer ersten Fertigungstechnik hergestellt sein und der zweite Kühlkörper mittels einer zweiten Fertigungstechnik. Dadurch ist ein erhöhter Grad an konstruktiver Freiheit gegeben, was eine bedarfsgerechte Konstruktion der Kühlkörper erlaubt.

Des Weiteren können der erste und zweite Kühlkörper zueinander im Wesentlichen parallel angeordnet sein. Darunter ist insbesondere zu verstehen, dass zumindest je ein flächiger Abschnitt, vorzugsweise ein größter flächiger Abschnitt, der Kühlkörper zueinander im Wesentlichen parallel angeordnet ist. Dadurch ist ein im Wesentlichen rechteckiger Bereich vorgebbar, im dem eine hydraulische Verbindung zwischen dem ersten und zweiten Kühlkörper ausgebildet ist. Ferner erlaubt die parallele Anordnung des ersten und zweiten Kühlkörpers eine vereinfachte Montage des Umrichters.

Darüber hinaus können im ersten und/oder zweiten Kühlkörper jeweils Kühlkanäle für eine Durchströmung mit einem Kühlfluid ausgebildet sein. Das Kühlfluid kann ist eine Flüssigkeit, durch die die Flüssigkeitskühlung des ersten und zweiten Kühlkörpers bereitgestellt wird. Der erste und zweite Kühlkörper sind durch das Kühlfluid selbst zwangskühlbar, insbesondere von innen zwangskühlbar. Dadurch wird eine leistungsfähige Entwärmung des ersten und/oder zweiten Kühlkörpers gewährleistet. Mittels des Kühlfluids in den Kühlkörpern sind diese in eine Wärmesenke entwärmbar, insbesondere in eine Wärmesenke, die vom Umrichter baulich getrennt ist, beispielsweise außerhalb eines Umrichterschranks, in dem der Umrichter angeordnet ist. Die Kühlkanäle in den Kühlkörpern können hydraulisch miteinander verbunden sein oder hydraulisch getrennt. Durch hydraulisch verbundene Kühlkanäle sind der erste und zweite Kühlkörper gemeinsam entwärmbar. Dadurch sind thermische Verlustleistungen am zumindest einen Energiespeicher bzw. den Halbleiterschaltern über das Kühlfluid abtransportierbar. Hydraulisch verbundene Kühlkanäle gehören ebenso zur thermisch leitenden Verbindung zwischen den Kühlkörpern. Alternativ erlauben hydraulisch getrennte Kühlkanäle, die Kühlkörper separat zu entwärmen. Jeder der Kühlkörper ist dadurch auf die jeweils am zumindest einen Energiespeicher bzw. den Halbleiterschaltern zu erwartende Abwärme optimiert auslegbar. Dies erlaubt eine bedarfsgerechte, materialund gewichtssparende Konstruktion der Kühlkörper.

In einer weiteren Ausführungsform des beanspruchten Umrichters ist zwischen dem ersten und zweiten Kühlkörper ein Zwischenraum ausgebildet, der zu einem Entwärmen einer Umgebungsluft des Umrichters, beispielsweise der Umgebungsluft in einem Innenraum eines Umrichterschranks, luftdurchströmbar ausgebildet. Die Umgebungsluft kann insbesondere Luft sein, die den beanspruchten Umrichter unmittelbar benetzt. Im bestimmungsgemäßen Betrieb kann die Umgebungsluft durch Abwärme vom Umrichter erwärmt werden, was in einem Umrichterschrank zu einer schädlichen Steigerung der Temperatur der Umgebungsluft führen kann. Eine thermische Verbindung zwischen dem ersten und zweiten Kühlkörper kann im Zwischenraum ausgebildet sein, so dass eine Luftdurchströmung aus der Umgebungsluft des Umrichters im Zwischenraum in den ersten und/oder zweiten Kühlkörper entwärmt wird. Der Zwischenraum, der durch den ersten und zweiten Kühlkörper zumindest teilweise begrenzt ist, kann als Luftkanal ausgebildet sein. Der Zwischenraum ist somit dazu ausgebildet, zur Entwärmung der Umgebungsluft des Umrichters eine vergrößerte Oberfläche bereitzustellen. Hierdurch wird insgesamt eine leistungsfähige und gleichzeitig kompakte Entwärmung für den Umrichter und seine Umgebungsluft bereitgestellt. Die thermische Leistungsfähigkeit der Kühlkörper kann somit auch für die Entwärmung der Umgebungsluft mitgenutzt werden. Der Umrichter kann weiter mit einem Lüfter versehen sein, der zu einem Anströmen des Zwischenraums am Umrichter angebracht sein kann. Der durch die Kühlkörper zumindest teilweise begrenzte Zwischenraum ist in besonderer Weise als Luftkanal geeignet, der vom Lüfter angeströmt wird. Lüfter sind in einer breiten Spanne an Größen und Leistungsklassen verfügbar, so dass der Lüfter in einfacher Weise an die Erfordernisse des beanspruchten Umrichters anpassbar ist. Der Lüfter ist an einer Stirnseite des Umrichters befestigbar und ist im Wesentlichen unabhängig von baulichen Beschränkungen auswählbar, die sich aus der elektrischen Konstruktion des Umrichters ergeben. Dadurch sind im beanspruchten Umrichter gegenüber dem Stand der Technik größere bzw. leistungsfähigere Lüfter einsetzbar. Ferner ist eine Entwärmung mittels eines Lüfters im beanspruchten Umrichter in einfacher Weise berechenbar, und damit vereinfacht simulierbar.

Ferner können im Zwischenraum zwischen dem ersten und zweiten Kühlkörper Kühlfinnen ausgebildet sein. Die Kühlfinnen können jeweils mit dem ersten und/oder zweiten Kühlkörper verbunden ausgebildet sein. Insbesondere können die Kühlfinnen jeweils mit nur einem der Kühlkörper verbunden sein oder mit dem ersten und zweiten Kühlkörper. Durch die Kühlfinnen ist der Versatz entlang der Aufbaurichtung des Umrichters zwischen dem ersten und zweiten Kühlkörper überbrückbar. Die Kühlfinnen können auch als mechanische Stützen zwischen den Kühlkörpern dienen. Die Kühlfinnen können mit dem ersten und zweiten Kühlkörper thermisch leitend verbunden sein und sich durch den luftdurchströmbaren Zwischenraum erstrecken. Die Kühlfinnen können durch den Lüfter anströmbar sein. Dadurch ist die von der Luftdurchströmung überstrichene Oberfläche vergrößert, wodurch die Leistungsfähigkeit der Entwärmung der Umgebungsluft des Umrichters gesteigert wird. Durch die über die Kühlfinnen vergrößerte Oberfläche wird ein Wärmeübergang aus der Luftdurchströmung in den ersten und/oder zweiten Kühlkörper unterstützt. Dementsprechend können die Kühlfinnen im Luftkanal angeordnet sein und sich im Wesentlichen entlang des Luftkanals erstrecken. Ferner kann zumindest in einer der Kühlfinnen ein Kühlkanal ausgebildet sein, die eine thermische Verbindung zum ersten und/oder zweiten Kühlkörper bildet. Dadurch ist die Leistungsfähigkeit der Entwärmung des Umrichters insgesamt weiter steigerbar. Durch die Kühlfinnen können im Wesentlichen rechteckige luftdurchströmte Querschnitte im Luftkanal definiert sein, die in einfacher Weise simulierbar sind.

Darüber hinaus kann die Zwischenkreisverschienung, die zumindest einen Halbleiterschalter mit dem zumindest einem Energiespeicher elektrisch verbindet, ungestuft ausgebildet sein. Dementsprechend kann die Zwischenkreisverschienung im Wesentlichen flach ausgebildet sein, also frei von Stufungen, beispielsweise durch Biegen. Korrespondierend zur Zwischenkreisverschienung können zumindest ein Energiespeicher und der damit verbundene Halbleiterschalter in Aufbaurichtung bündig ausgebildet sein. Die Zwischenkreisverschienung kann beispielsweise als Stanzteil ausgebildet sein, das frei von einer Biegebearbeitung ist. Dadurch wird die Herstellung des beanspruchten Umrichters vereinfacht. Die Zwischenkreisverschienung weist ferner eine reduzierte Induktivität auf.

Des Weiteren kann der Umrichter eine Stromschiene aufweisen, die auf einer den Halbleiterschaltern abgewandten Seite des ersten Kühlkörpers befestigt sein kann. Alternativ oder ergänzend kann die Stromschiene auf einer dem zumindest einen Energiespeicher abgewandten Seite des zweiten Kühlkörpers befestigt sein. Durch die Stromschiene kann vom ersten bzw. zweiten Kühlkörper elektrisch isoliert sein, beispielsweise durch eine geeignete Zwischenlage oder Beschichtung. Die Stromschiene ist dazu ausgebildet und angeordnet, den ersten bzw. zweiten Kühlkörper als Wärmesenke zu nutzen und den Umrichter so zu entwärmen. Die Stromschiene kann elektrisch mit zumindest einem Halbleiterschalter elektrisch verbunden sein. Weiter kann die Stromschiene als ungebogenes Stanzteil ausgebildet sein und ist somit kosteneffizient herstellbar. Die Stromschiene kann insbesondere flach und ungebogen ausgebildet sein, also frei von einer Biegebearbeitung. Das Gleiche gilt für eine isolierende Zwischenschicht, die zwischen auf einer Stromschiene angeordnet sein kann. Die isolierenden Zwischenschichten können dadurch ebenso flächig auf der Stromschiene angebracht werden, was eine automatisierbare Fertigung erlaubt. Auch dadurch wird die Herstellung des beanspruchten Umrichters vereinfacht.

In einer weiteren Ausführungsform des beanspruchten Umrichters ist eine Halbbrücke, zu der die Halbleiterschalter gehören, frei von Snubber-Kondensatoren. Der beanspruchte Umrichter, insbesondere dessen Stromschiene, weist reduzierte Streuinduktivität auf, durch die die Verwendung von Snubber-Kondensatoren entbehrlich ist. Der beanspruchte Umrichter weist folglich eine reduzierte Bauteilanzahl auf und ist dadurch schneller herstellbar. Ferner wird durch die reduzierte Bauteilanzahl die Zuverlässigkeit des beanspruchten Umrichters gesteigert.

Ferner kann der zweite Kühlkörper im beanspruchten Umrichter in einer Lagenrichtung den zumindest einen Energiespeicher einseitig überragen. Unter der Lagenrichtung ist eine Richtung entlang des im Wesentlichen flächig ausgebildeten zweiten oder ersten Kühlkörpers zu verstehen. Die Lagenrichtung ist im Wesentlichen senkrecht zur Aufbaurichtung des Umrichters. Der zweite Kühlköper überragt somit den zumindest einen Energiespeicher und bildet einen Abschnitt, der entlang der Aufbaurichtung einen Abschnitt des ersten Kühlkörpers überlappt. Die entsprechenden Abschnitte des ersten und zweiten Kühlkörpers können dadurch den Zwischenraum zwischen den Kühlkörpern teilweise begrenzen. Ebenso können die entsprechenden Abschnitte zum Luftkanal gehören, der vom Lüfter anströmbar ist und/oder in dem Kühlfinnen vorgesehen sein können. Über eine entsprechende Dimensionierung des ersten und/oder zweiten Kühlkörpers ist somit ein Querschnitt des Zwischenraums bzw. des zugehörigen Luftkanals vorgebbar. Der zweite Kühlkörper kann den zumindest einen Energiespeicher in Lagenrichtung zumindest teilweise so weit überragen, dass er dem ersten Kühlkörper gegenüberliegt. Folglich kann der Zwischenraum bzw. der Kühlkanal in Lagenrichtung eine Breite haben, die maximal der Abmessung des ersten Kühlkörpers in Lagenrichtung entspricht. Folglich ist der beanspruchte Umrichter in puncto Kühlleistung in einfacher Weise skalierbar. Dadurch ist der Umrichter mit gesteigerter elektrischer Leistung betreibbar, durch die korrespondierend erhöhte Kühlleistung erforderlich ist. Gleichzeitig ist der beanspruchte Umrichter platzsparend ausbildbar. Der zweite Kühlkörper überragt den zumindest einen Energiespeicher in Lagenrichtung somit zu einer Steigerung einer elektrischen Leistungsaufnahmefähigkeit des Umrichters.

Darüber hinaus können der erste und/oder zweite Kühlkörper durch Additive Fertigung hergestellt sein, beispielsweise durch Lasersintern, 3D-Druck, oder Binder-Jetting. Dadurch sind Kühlkanäle in den Kühlkörpern und/oder Kühlfinnen in einfacher Weise an den beanspruchten Umrichter anpassbar. Insbesondere sind die Kühlkanäle an die Erfordernisse des Umrichters anpassbar, wodurch eine gesteigerte Kühlleistung für den Umrichter erzielbar ist.

Die zugrundeliegende Aufgabenstellung wird ebenso durch einen erfindungsgemäßen Umrichterschrank gelöst. Der Umrichterschrank umfasst Wandungen, in denen zumindest ein Umrichter angeordnet ist. Erfindungsgemäß ist der Umrichter nach einer der oben skizzierten Ausführungsformen ausgebildet. Der Umrichter kann im Wesentlichen vertikal angeordnet sein, wobei der Lüfter an einem bodenseitigen Ende angeordnet ist. Dementsprechend ist der Umrichterschrank entwärmbar, indem die Luftdurchströmung deckelseitig ausgestoßen wird. Durch die gesteigerte Kühlleistung des beanspruchten Umrichters ist der Umrichterschrank dazu geeignet, verglichen mit Umrichterschränken gemäß dem Stand der Technik, eine erhöhte Anzahl an Umrichtern aufzunehmen. Alternativ oder ergänzend ist der beanspruchten Umrichterschrank, verglichen mit Umrichterschränken gemäß dem Stand der Technik, erhöhte elektrische Leistung aufzunehmen. Die Merkmale des Umrichters sind dementsprechend analog auf den beanspruchten Umrichterschrank übertragbar.

Die eingangs beschriebene Aufgabenstellung wird gleichermaßen durch ein lösungsgemäßes Verfahren zum Simulieren eines Betriebsverhaltens eines Umrichters gelöst. Das Verfahren umfasst einen ersten Schritt, in dem ein Datensatz bereitgestellt wird, durch den eine Funktionsweise zumindest eines Teils des zu simulierenden Umrichters nachstellbar ist. Insbesondere kann der Datensatz ein digitales Abbild des Umrichters umfassen, also dessen Aufbau darstellen. Dies kann eine Größe, Lage, Form, Materialangabe und/oder zugehörige Materialeigenschaften von Kühlkörpern, zumindest eines Energiespeichers, zumindest eines Halbleiterschalters und/oder eines Lüfters umfassen. Alternativ oder ergänzend kann der Datensatz eine Angabe über ein Wärmeabgabeverhalten, ein Wärmeleitverhalten und/oder ein Wärmeabgabeverhalten umfassen.

Weiter umfasst das lösungsgemäße Verfahren ein Vorgeben zumindest einer Betriebsbedingung, die das zu simulierende Betriebsverhalten charakterisiert. Die Betriebsbedingung kann eine elektrische Auslastung des Umrichters und/oder eine damit einhergehende Wärmefreisetzung am zumindest einen Halbleiterschalter und/oder am zumindest einen Energiespeicher umfassen. Alternativ oder ergänzend kann eine Umgebungstemperatur und/oder eine Angabe über eine Luftumströmung des Umrichters zu den Betriebsbedingungen gehören. Ebenso gehört ein dritter Schritt zum Verfahren, in dem ein Computerprogrammprodukt ausgeführt wird, mit dem im ersten Schritt bereitgestellte Datensatz in Kombination mit der im zweiten Schritt vorgegebenen zumindest einen Betriebsbedingung verarbeitet wird. Das Computerprogrammprodukt ist dazu ausgebildet, das Betriebsverhalten des Umrichters anhand des Datensatzes und der zumindest einen Betriebsbedingung nachzustellen. Hierbei wird zumindest ein Betriebskennwert ermittelt. Der Betriebskennwert kann beispielsweise eine Temperaturverteilung an einer Oberfläche und/oder im Material zumindest eines Kühlkörpers, zumindest eines Energiespeichers und/oder zumindest eines Halbleiterelements. Alternativ oder ergänzend kann der Betriebskennwert auch eine thermische Angabe über die Flüssigkeit umfassen, mit der zumindest einer der Kühlkörper gekühlt ist. Das Computerprogrammprodukt kann dazu aus sogenannter Digitaler Zwilling ausgebildet sein, wie beispielsweise in der Druckschrift US 2017/286572 A1 näher beschrieben. Der Offenbarungsgehalt von US 2017/286572 A1 wird durch Verweisung in die vorliegende Anmeldung miteinbezogen.

Weiter gehört ein vierter Schritt zum lösungsgemäßen Verfahren, bei dem der im dritten Schritt ermittelte zumindest eine Betriebskennwert an einen Benutzer und/oder eine Datenschnittstelle ausgegeben wird. Die Datenschnittstelle ist dazu geeignet, Resultate des oben dargestellten Verfahrens an andere simulationsgerichtete Computerprogramme auszugegeben. Lösungsgemäß ist der Umrichter, der durch das Verfahren simuliert wird, gemäß einer der oben beschriebenen Ausführungsformen ausgebildet. Die Merkmale des beanspruchten Umrichters sind dementsprechend auf das Verfahren übertragbar.

Die oben dargestellte Aufgabe wird ebenso durch ein lösungsgemäßes Computerprogrammprodukt , das jedoch nicht Teil des Anspruchsumfangs ist, gelöst . Das Computerprogrammprodukt umfasst Befehle, die bei einer Ausführung des Computerprogrammprodukts durch einen Computer diesen dazu veranlassen, ein Betriebsverfahren eines Umrichters zu simulieren. Lösungsgemäß ist das Computerprogrammprodukt dazu ausgebildet, ein Verfahren nach einer der oben skizzierten Ausführungsformen durchzuführen. Alternativ kann der Umrichter, der durch das Computerprogrammprodukt simuliert wird, gemäß einer der oben skizzierten Ausführungsformen ausgebildet sein. Weiter alternativ oder ergänzend kann das Computerprogrammprodukt dazu ausgebildet sein, korrespondierend ein Betriebsverhalten eines Umrichterschranks nach einer der oben beschriebenen Ausführungsformen zu simulieren.

Zum Betriebsverfahren , das ebenfalls nicht Teil des Anspruchsumfangs ist, kann ein elektrisches Verhalten des Umrichters und/oder dessen thermisches Verhalten gehören. Das thermische Verhalten kann eine Wärmefreisetzung an einem Halbleiterschalter, einem Energiespeicher, eine Wärmeübertragung auf eine Zwischenkreisverschienung, eine Stromschiene, einen Kühlkörper, oder ein Wärmeleitverhalten in einer dieser Komponenten umfassen. Ebenso kann das Wärmeleitverhalten einen Wärmeübergang auf ein Kühlfluid, eine Kühlfinne und/oder eine Luftdurchströmung umfassen, die eine dieser Komponenten überstreicht. Das Betriebsverhalten kann abhängig von zumindest einem Betriebsparameter wie beispielswiese eine elektrische Leistungsaufnahme des Umrichters und/oder eine Umgebungslufttemperatur ermittelt werden. Ferner kann eine Lüfterdrehzahl bzw. ein Lüfterdurchsatz ein vorgebbarer Betriebsparameter sein. Die Betriebsparameter können durch einen Benutzer und/oder eine geeignete Datenschnittstelle, beispielsweise von einem weiteren simulationsgerichteten Computerprogramm, bereitgestellt werden. Das Computerprogrammprodukt kann weiter ein Physik-Modul umfassen, mit dem das Betriebsverhalten nachstellbar, also simulierbar ist. Ebenso kann das Computerprogrammprodukt dazu ausgebildet sein, Simulationsresultate an einen Benutzer und/oder eine geeignete Datenschnittstelle auszugeben, beispielsweise an ein weiteres simulationsgerichtetes Computerprogramm. Das Computerprogrammprodukt , welches nicht Teil des Anspruchsumfangs ist, kann als sogenannter Digitaler Zwilling ausgebildet sein, wie beispielsweise in US 2017/0286572 A1 beschrieben. Der Offenbarungsgehalt von US 2017/0286572 A1 wird durch Verweisung in die vorliegende Anmeldung miteinbezogen.

Der simulierte Umrichter ist durch seinen Aufbau in vorteilhafter Weise simulierbar. Der Luftkanal, insbesondere mit Kühlfinnen, kann zumindest einen im Wesentlichen rechteckigen Querschnitt definieren, der luftdurchströmt ist. Derartige rechteckige Querschnitte sind in vereinfachter Weise simulierbar und sind beispielsweise mit hinreichender Genauigkeit durch eine Kennlinie darstellbar, die die vorliegende Kühlleistung abhängig von zumindest einem vorliegenden Betriebsparameter darstellt. Ferner ist durch den beanspruchten Umrichter eine derart gesteigerte Kühlleistung erzielbar, dass Störeinflüsse und/oder Rückkopplungseffekte, die sich bei Umrichtern oder Umrichterschränken nach dem Stand der Technik ergeben, beispielsweise aus einer Erwärmung der Umgebungsluft ergeben, weitestgehend vernachlässigbar sind. Dadurch ist eine Simulation eines beanspruchten Umrichters bzw. eines beanspruchten Umrichterschranks vereinfacht. Das Computerprogrammprodukt , welches nicht Teil des Anspruchsumfangs ist, liefert mit reduzierter Rechenleistung aussagekräftige Simulationsresultate. Ferner ist das Computerprogrammprodukt so im Wesentlichen echtzeitfähig. Durch das Computerprogrammprodukt ist ein beanspruchter Umrichter bzw. Umrichter im Betrieb genauer überwachbar. Beispielsweise können Messwerte von Sensoren im Umrichter oder Umrichterschrank, insbesondere Temperaturmesswerte, plausibilisiert werden und dadurch eine defekte Komponente identifiziert werden. Das Computerprogrammprodukt kann monolithisch ausgebildet sein, also auf einer einzigen Hardwareplattform ausführbar sein. Alternativ kann das Computerprogrammprodukt modular ausgebildet sein, also Teilprogramme umfassen, die auf separaten Hardwareplattformen ausführbar sind, über eine kommunikative Datenverbindung zusammenwirken und dadurch die bestimmungsgemäße Simulation bereitstellen.

In einer Ausführungsform des Computerprogrammprodukts weist dieses eine Datenschnittstelle auf, die dazu ausgebildet ist, das Computerprogrammprodukt mit zumindest einem Sensor zu verbinden, der einem korrespondierenden physikalischen Umrichter zugeordnet sind. Der physikalische Umrichter ist im bestimmungsgemäßen Betrieb des Computerprogrammprodukts mit diesem überwachbar. Die Datenschnittstelle ist dazu ausgebildet, anhand von Messsignalen bzw. Messwerten, die von dem zumindest einen Sensor bereitgestellt werden, einen Grad an Übereinstimmung zwischen dem simulierten Betriebsverhalten und dem realen Betriebsverhalten zu ermitteln. Insbesondere kann der im Verfahren, und damit vom Computerprogrammprodukt, ermittelte Betriebskennwert, mit einem im physikalischen Umrichter mit dem zumindest einen Sensor erfassten Messsignal bzw. Messwert korrespondieren. Weiter kann die Datenschnittstelle als ein sogenanntes Application Programming Interface, kurz API, ausgebildet sein.

Die Erfindung wird im Folgenden anhand einzelner Ausführungsformen in Figuren näher erläutert. Die Figuren sind insoweit in gegenseitiger Ergänzung zu lesen, dass gleiche Bezugszeichen in unterschiedlichen Figuren die gleiche technische Bedeutung haben. Die Merkmale der einzelnen Ausführungsformen sind untereinander auch kombinierbar. Ferner sind die Merkmale der in den Figuren gezeigten Ausführungsformen mit den oben skizzierten Merkmalen kombinierbar. Es zeigen im Einzelnen:
- FIG 1: eine erste Ausführungsform des beanspruchten Umrichters in einer Seitenansicht;
- FIG 2: einen Abschnitt einer zweiten Ausführungsform des beanspruchten Umrichters in einer geschnittenen Schrägansicht;
- FIG 3: den Abschnitt nach FIG 2 in einer ungeschnittenen Schrägansicht;
- FIG 4: eine dritte Ausführungsform des beanspruchten Umrichters in einer Schrägansicht von unten;
- FIG 5: die dritte Ausführungsform des beanspruchten Umrichters in einer Schrägansicht von oben;
- FIG 6: eine Ausführungsform des beanspruchten Umrichterschranks.

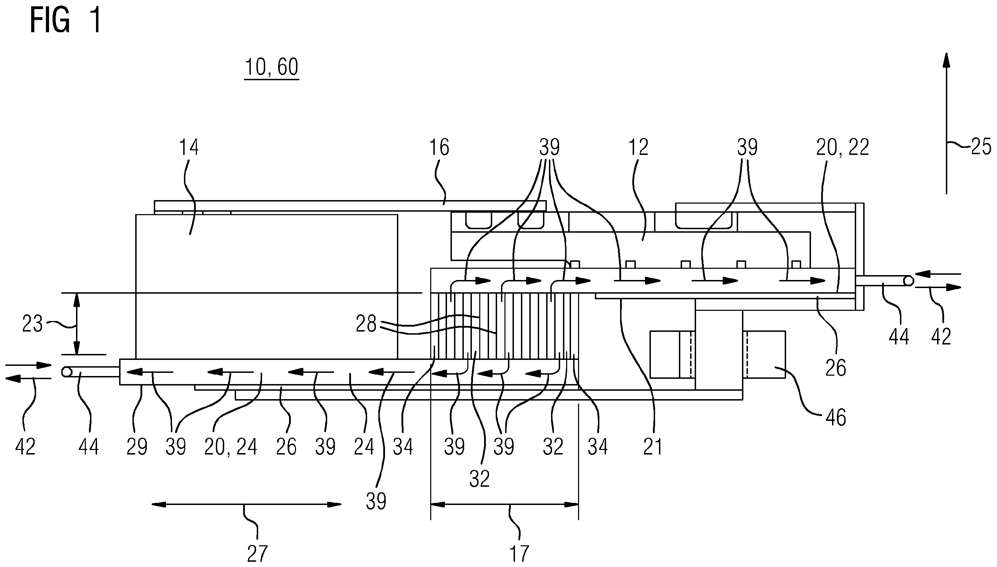

Eine erste Ausführungsform des beanspruchten Umrichters 10 ist in FIG 1 schematisch in einer Seitenansicht gezeigt. Der Umrichter 10 umfasst einen Energiespeichern 14, der als Kondensator ausgebildet ist und mit Halbleiterschaltern 12 verbunden sind. Der Energiespeicher 14 ist über eine sogenannte Zwischenkreisverschschienung 16 mit einem Halbleiterschalter 12 elektrisch leitend verbunden. Der Umrichter 10 umfasst ebenso Kühlkörper 20, über die jeweils die Energiespeicher 14 und die Halbleiterschalter 12 in einem bestimmungsgemäßen Betrieb zu entwärmen sind. Im bestimmungsgemäßen Betrieb werden durch die Halbleiterschalter 12 und den zumindest einen Energiespeicher 14 Wärmeströme 39 erzeugt, die in die Kühlkörper 20 eingeleitet werden. Die Halbleiterschalter 12 sind auf einem ersten Kühlkörper 22 angeordnet und mit diesem in thermisch leitendem Kontakt. Am ersten Kühlkörper 22 ist eine Kühlfluidleitung 44 ausgebildet, durch die ein Kühlfluid 42 in den ersten Kühlkörper 22 einleitbar und/oder ausleitbar ist. Vom Kühlfluid 42 aufgenommene Wärme ist so vom Umrichter 10 wegführbar, beispielsweise zu einer baulich getrennten Wärmesenke, die in FIG 1 nicht näher gezeigt ist. Analog der zumindest eine Energiespeicher 14 auf einem zweiten Kühlkörper 24 angeordnet und ist mit diesem in thermisch leitendem Kontakt. Ebenso ist der zweite Kühlkörper 24 analog dem ersten Kühlkörper 22 mit einer Kühlfluidleitung 44 versehen, in der ein Kühlfluid 42 einleitbar und/oder ausleitbar ist. Der erste und zweite Kühlkörper 22, 24 sind jeweils im Wesentlichen flächig ausgebildet. Dementsprechend erstrecken sich der erste und zweite Kühlkörper 22, 24 im Wesentlichen entlang einer Lagenrichtung 27 und sind in ihrem thermischen Verhalten, also ihrem Wärmeleitverhalten, im Wesentlichen als Scheiben beschreibbar. Der erste und zweite Kühlkörper 22, 24 sind parallel angeordnet und entlang einer Aufbaurichtung 25 des Umrichter 10 zueinander versetzt angeordnet. Die Aufbaurichtung 25 ist in FIG 1 durch den entsprechenden Pfeil versinnbildlicht.

Der zweite Kühlkörper 24 ist benachbart zum zumindest einen Energiespeicher 14 verlängert ausgebildet und überragt diese entlang der Lagenrichtung 27. Der zumindest eine Energiespeicher 14 wird durch den zweiten Kühlkörper 24 um eine Überragbreite 17 überragt, in deren Bereich der zweite Kühlkörper 24 dem ersten Kühlkörper 22 gegenüberliegt. Im Bereich der Überragbreite 17 liegt ein Zwischenraum 23 zwischen dem ersten und zweiten Kühlkörper 22, 24 vor. Im Bereich des Zwischenraums 23 sind Stützen 34 angeordnet, durch die der erste Kühlkörper 22 auf dem zweiten Kühlkörper 24 abgestützt ist. Ebenso wird durch die Stützen 34 eine thermische leitende Verbindung zwischen dem ersten und zweiten Kühlkörper 22, 24 hergestellt. Ebenso ist zwischen den Stützen 34, und damit im Zwischenraum 32, eine Mehrzahl an Kühlfinnen 28 ausgebildet, die mit dem ersten und zweiten Kühlkörper 22, 24 ebenso thermisch leitend verbunden sind. Im bestimmungsgemäßen Betrieb anfallende Wärmeströme 39 aus dem zumindest einen Energiespeicher 14 und den Halbleiterschaltern 12 sind in den ersten und zweiten Kühlkörper 22, 24 einleitbar und über das Kühlfluid 42 jeweils abführbar. Ebenso werden Wärmeströme 39 aus den Kühlfinnen 28 und den Stützen 34 in den ersten und zweiten Kühlkörper 22, 24 eingeleitet und über das Kühlfluid 42 abgeführt. Der Zwischenraum 23 ist senkrecht zur Zeichenebene in FIG 1 luftdurchströmbar und bildet somit einen Luftkanal 32. Die Kühlfinnen 28 sind derart angeordnet, dass der Luftkanal 32, also ein zwischen den Stützen 34 liegender luftdurchströmbarer Querschnitt, durch die Kühlfinnen 28 segmentiert ist. Durch die Kühlfinnen 28 wird eine vergrößerte Oberfläche bereitgestellt, die einen Wärmeübergang von Luft im luftdurchströmten Querschnitt zu den Kühlkörpern 22, 24 verbessert. Die Kühlfinnen 28 und/oder die Stützen 34 können durch Additive Fertigung hergestellt sein. Ferner ist der Zwischenraum 23 entlang der Aufbaurichtung 25 derart ausgebildet, dass zumindest einer der Halbleiterschalter 12 mit dem zumindest einen Energiespeicher 14 in Aufbaurichtung 25 bündig ist. Folglich ist zumindest eine der Zwischenkreisverschienungen 16, die einen Halbleiterschalter 12 mit dem zumindest einen Energiespeicher 14 verbindet, ungestuft ausgebildet ist. Die entsprechende Zwischenkreisverschienung 16 ist im Wesentlichen flach ausgebildet, insbesondere streifenförmig. Die entsprechende Zwischenkreisverschienung 16 ist als Stanzteil ausgebildet und dadurch kosteneffizient herstellbar. Ferner sind am ersten und der zweiten Kühlkörper 22, 24 je auf einer den Halbleiterschaltern 12 bzw. dem zumindest einen Energiespeicher 14 abgewandten Seite 21, 29 elektrisch isolierende Zwischenlagen 26 angebracht. Die Zwischenlagen 26 isolieren eine Stromschiene 18 elektrisch vom ersten bzw. zweiten Kühlkörper 22, 24.

Entlang der Aufbaurichtung 25 ist in einem Bereich zwischen dem ersten und zweiten Kühlkörper 22, 24 ein Erfassungsmittel 46 angeordnet, das als Strommessvorrichtung ausgebildet ist. Das Erfassungsmittel 46 ist elektrisch mit dem Halbleiterschalter 12 verbunden und ist mit einer nicht näher dargestellten Steuereinheit des Umrichters 10 verbindbar. Die Stromschiene 18 ist als gebogenes Stanzteil ausgebildet und stellt einen elektrischen Anschluss für den Umrichter 10 bereit. Die Zwischenlage 26 ist thermisch durchlässig und stellt eine thermisch leitende Verbindung vom ersten bzw. zweiten Kühlkörper 22, 24 zur Stromschiene 18 her. Die Stromschiene 18 unterstützt somit ebenfalls die Entwärmung des Umrichters 10. Weiter liegt ein Computerprogrammprodukt 60 vor, durch das der Umrichter 10 nach FIG 1 in seinem Betriebsverhalten nachgestellt wird. Das Computerprogrammprodukt 60 ist hierbei als Digitaler Zwilling des Umrichters 10 ausgebildet.

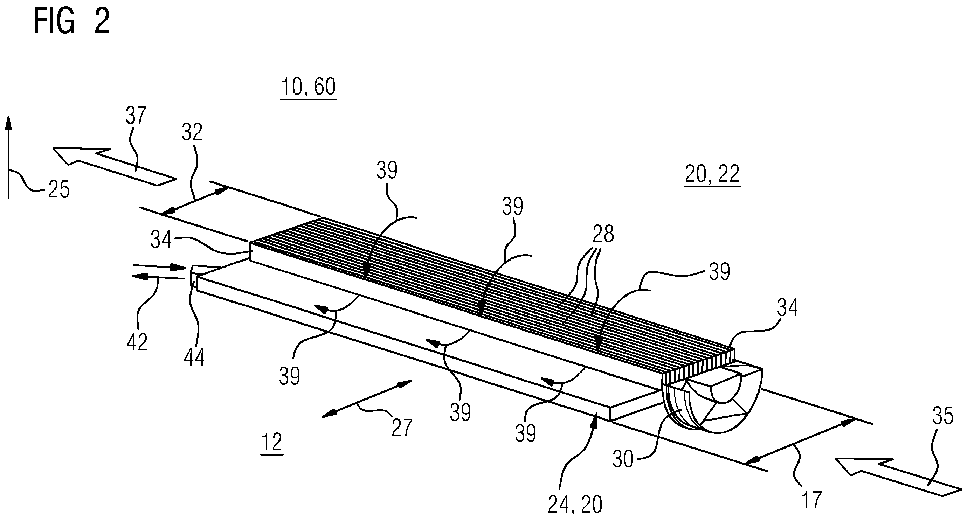

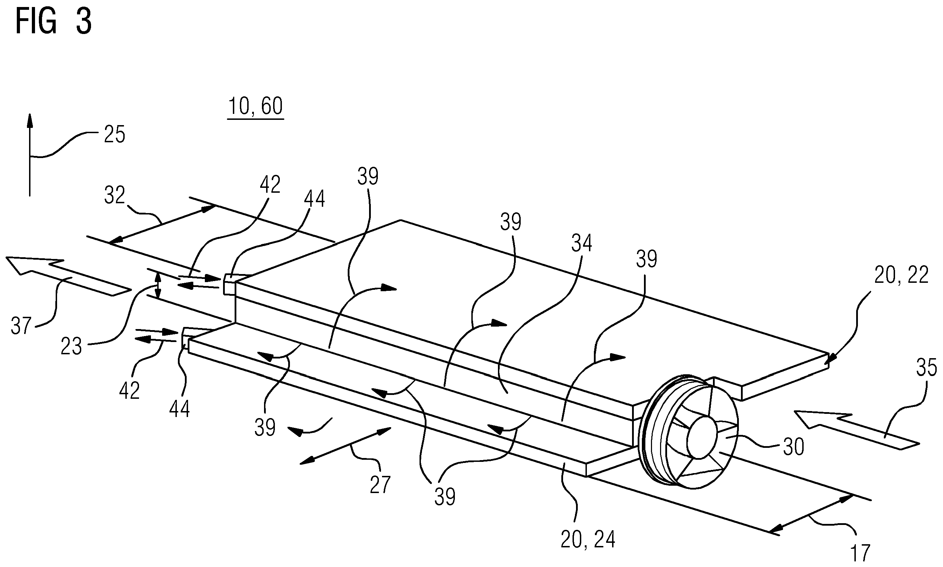

In FIG 2 und FIG 3 ist schematisch eine zweite Ausführungsform des beanspruchten Umrichters 10 ausschnittsweise dargestellt. FIG 2 zeigt den Aufbau in einer geschnittenen Schrägansicht und FIG 3 in einer ungeschnittenen Schrägansicht. Der Umrichter 10 umfasst einen zweiten Kühlkörper 24, der den nicht näher dargestellten zumindest einen Energiespeicher 14 entlang einer Lagenrichtung 27 um eine Überragbreite 17 überragt. Im Bereich, der durch die Überragbreite 17 vorgegeben ist, sind Stützen 34 ausgebildet, zwischen denen jeweils Kühlfinnen 28 positioniert sind. Die Kühlfinnen 28 erstrecken sich parallel und segmentieren einen Luftkanal 32 zwischen dem Stützen 34. An einer Kante des zweiten Kühlkörpers 24 ist ein Lüfter 30 angeordnet, dessen Durchmesser zumindest der Breite des Kühlkanals 32 entspricht. Durch den Lüfter 30 ist in vorgebbarer Weise eine Luftanströmung 35 erzwingbar, die den Umrichter 10 durchströmt. Die Luft der Luftanströmung 35 kann einer Umgebungsluft entnommen sein. Der Kühlkanal 32 wird folglich durch den Lüfter 30 angeströmt. Wärmeströme 39 aus den Kühlfinnen 28 werden in den zweiten Kühlkörper 24 und einen in FIG 3 näher gezeigten ersten Kühlkörper 22 eingeleitet. Die so von der Luftanströmung 35 in die Kühlfinnen 28 eingeleitete Wärme wird durch die Kühlkörper 22, 24 aufgenommen und über das Kühlfluid 42 abgeführt. Die Luftabströmung 37 ist dadurch gegenüber der Luftanströmung 35 gekühlt und kann in die Umgebungsluft eingeleitet werden. Die Luftmasse, die als Luftanströmung 35 zugeführt wird und als Luftabströmung 37 abgeführt wird, stellt im Luftkanal 32 eine Luftdurchströmung dar. Alternativ kann die Strömungsrichtung der Luftdurchströmung auch umgekehrt sein. Der Luftkanal 32 ist durch den ersten Kühlkörper 22 abgeschlossen, der sich in Aufbaurichtung 25 an die Stützen 34 und die Kühlfinnen 28 anschließt. Der erste und zweite Kühlkörper 22, 24 sind thermisch mit den Stützen 34 und den Kühlfinnen 28 thermisch leitend verbunden ausgebildet. Der Umrichter 10 wird in seinem Betriebsverhalten, das die Freisetzung von Wärme in Form von Wärmeströmen 39 umfasst, durch ein Computerprogrammprodukt 60 simuliert, das als Digitaler Zwilling des Umrichters 10 ausgebildet ist.

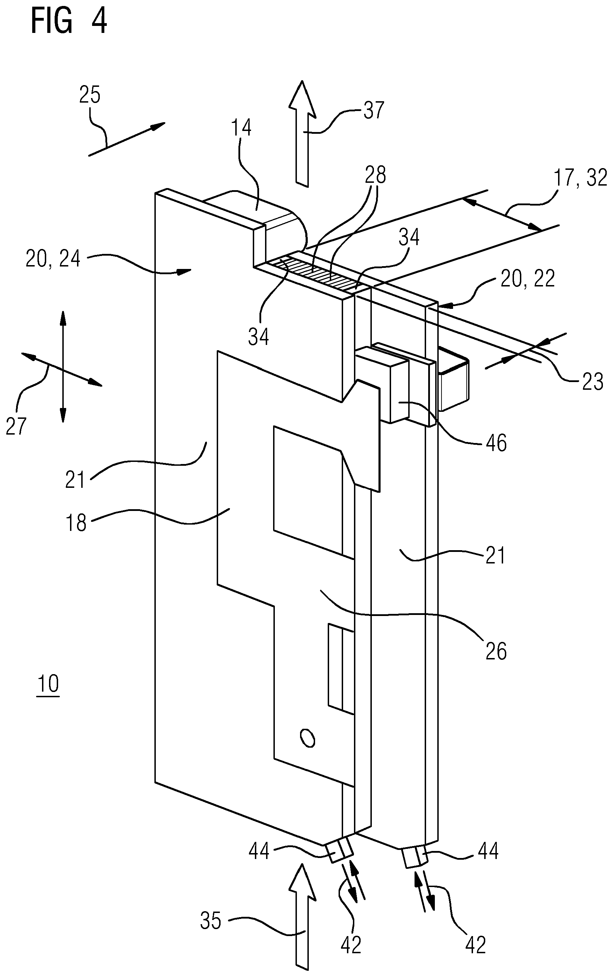

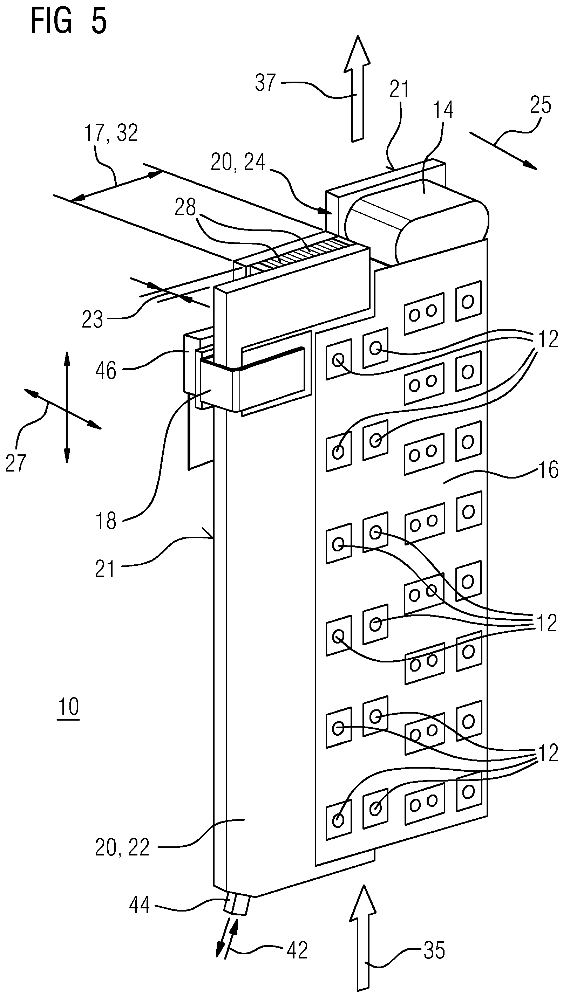

Weiter zeigen FIG 4 und FIG 5 eine dritte Ausführungsform des beanspruchten Umrichters 10 gezeigt. Der Umrichter 10 ist in FIG 4 und FIG 5 von entgegensetzten Seiten in einer Schrägansicht gezeigt. Der Umrichter 10 ist, bezogen auf eine Aufbaurichtung 25, in FIG 4 von unten gezeigt und in FIG 5 von oben. Der Umrichter 10 umfasst Kühlkörper 20, auf denen Halbleiterschalter 12 und zumindest ein Energiespeicher 14 angeordnet sind. Der zumindest eine Energiespeicher 14, der als Kondensatoren ausgebildet sind, ist auf einem ersten Kühlkörper 22 angeordnet und die Halbleiterschalter 12 auf einem zweiten Kühlkörper 24. Die Halbleiterschalter 12 sind in FIG 5 teilweise durch eine Zwischenkreisverschienung 16 verdeckt, die ungestuft ausgebildet ist und zumindest einen der Halbleiterschalter mit Energiespeichern 14 elektrisch verbindet. Die Zwischenkreisverschienung 16 ist als Stanzteil ausgebildet und im Wesentlichen flach. Entlang der Aufbaurichtung 25 sind der erste und zweite Kühlkörper 22, 24 beabstandet angeordnet. Ferner überragt der zweite Kühlkörper 24 die Energiespeicher 14 um eine Überragbreite 17 und begrenzt zusammen mit dem ersten Kühlkörper 22 teilweise einen Zwischenraum 23. Im Bereich des Zwischenraums 23 ist ein Luftkanal 32 ausgebildet, der entlang einer Lagenrichtung 27 durchströmbar ist. Der Luftkanal 32 ist durch eine Mehrzahl an Kühlfinnen 28 segmentiert, durch die eine Luftanströmung 35 durch den Umrichter 10 gelenkt wird. Die Kühlfinnen 28 sind thermisch leitend mit den Kühlkörpern 20 verbunden, so dass die Luftanströmung 35 als gekühlte Luftabströmung 37 aus dem Umrichter 10 austritt. Der Umrichter 10 ist ferner mit einer Stromschiene 18 versehen, die auf einer den Halbleiterschaltern 12 abgewandten Seiten 21 des zweiten Kühlkörpers 24 angebracht ist. Die Stromschiene 18 ist mehrteilig ausgebildet und durch eine Zwischenlage 26 elektrisch vom zweiten Kühlkörper 24 isoliert ist. Die Zwischenlage 26 ist thermisch leitend ausgebildet und stellt eine thermisch leitende Verbindung zur Stromschiene 18 her. Die Entwärmung des Umrichters 10 wird so durch die Stromschiene 18 weiter unterstützt. Der Umrichter 10 wird in seinem Betriebsverhalten durch ein Computerprogrammprodukt 60 simuliert, das als Digitaler Zwilling des Umrichters 10 ausgebildet ist.

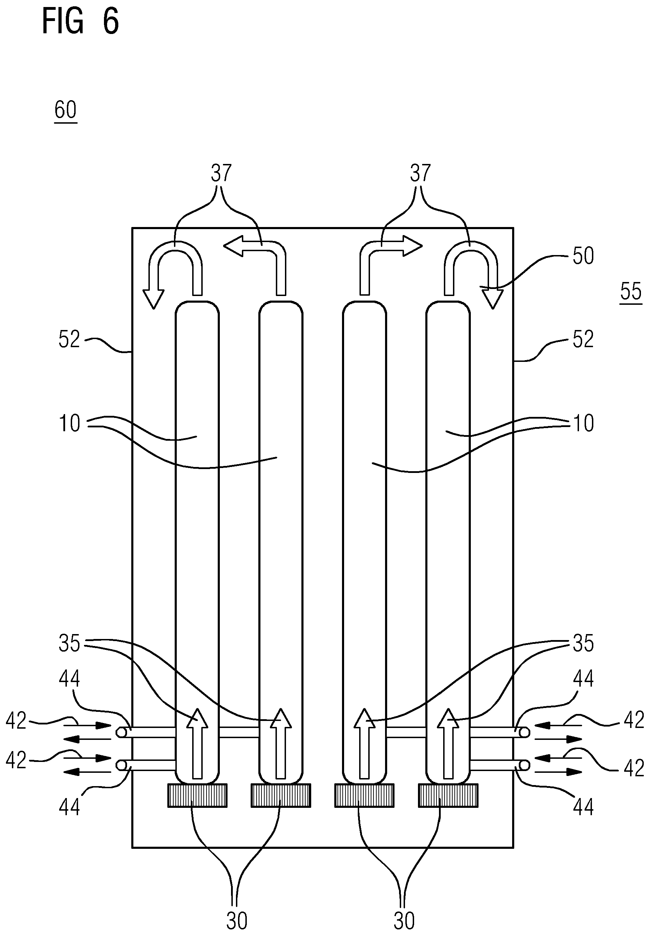

Eine Ausführungsform des beanspruchten Umrichterschranke 50 ist in FIG 6 schematisch dargestellt. Der Umrichterschrank 50 umfasst Wandungen 52, die eine Mehrzahl an Umrichtern 10 von einer Umgebung 55 trennen. Die Umrichter 10 sind jeweils mit einem Lüfter 30 versehen, durch den die Umrichter 10 mit Luft anströmbar sind. Durch eine jeweils mit den Lüftern 30 hervorgerufene Luftanströmung 35 ist die Umgebungsluft aus dem Innenraum des Umrichters 10 entwärmbar. Die von der Luftanströmung 35 transportierte Wärme wird im Umrichter 10 aufgenommen und eine gekühlte Luftabströmung 37 im Innenraum des Umrichterschrankes 50 abgegeben. Die vom Umrichter 10 aufgenommene Wärme wird über nicht näher gezeigte Kühlkanäle mit einem Kühlfluid abgeführt. Zumindest einer der Umrichter 10 ist gemäß einer der oben skizzierten Ausführungsformen ausgebildet und weist eine gesteigerte Kühlleistung auf. Dadurch ist der Umrichterschrank 50 dazu geeignet, gegenüber Umrichterschränken nach dem Stand der Technik, eine erhöhte Anzahl an Umrichtern 10 aufzunehmen oder diese enger beabstandet anzuordnen. Der Umrichterschrank 50 ist gegenüber der Umgebung 55 hermetisch geschlossen, so dass ein Luftaustausch mit der Umgebung 55 vermeidbar ist. Hierdurch ist ein Eintrag von Verschmutzungen aus der Umgebung 55 minimiert. Zumindest einer der Umrichter 10 in FIG 6 ist durch ein Computerprogrammprodukt 60 in seinem Betriebsverhalten nachgestellt. Das Computerprogrammprodukt 60 ist als Digitaler Zwilling des entsprechenden Umrichters 10 ausgebildet.

## Patentansprüche

1. Umrichter (10), umfassend eine Mehrzahl an Halbleiterschaltern (12) und zumindest einen Energiespeicher (14), eine Zwischenkreisverschienung (16), einen ersten Kühlkörper (22) zu einem Entwärmen der Halbleiterschalter (12) und einen zweiten Kühlkörper (24) zu einem Entwärmen des zumindest einen Energiespeichers (14), wobei der erste und/oder zweite Kühlkörper (22, 24) flüssigkeitsgekühlt sind, wobei der erste und zweite Kühlkörper (22, 24) zu einem Entwärmen von Umgebungsluft in einer Umgebung (55) des Umrichters (10) entlang einer Aufbaurichtung (25) des Umrichters (10) zueinander versetzt angeordnet sind, wobei die Aufbaurichtung der Richtung entspricht, entlang der zumindest eine Halbleiterschalter (12) auf den ersten Kühlkörper (22) aufgesetzt ist und/oder der zumindest eine Energiespeicher (14) auf den zweiten Kühlkörper (24) aufgesetzt ist, **dadurch gekennzeichnet, dass** der erste Kühlkörper (22) mit dem zweiten Kühlkörper (24) über Kühlfinnen (28) verbunden ist.

2. Umrichter (10) nach Anspruch 1, **dadurch gekennzeichnet, dass** der erste und zweite Kühlkörper (22, 24) zumindest im Bereich der Halbleiterschalter (12) bzw. des zumindest einen Energiespeichers (14) flächig ausgebildet sind.

3. Umrichter (10) nach Anspruch 1 oder 2, **dadurch gekennzeichnet, dass** der erste und zweite Kühlkörper (22, 24) zueinander parallel angeordnet sind.

4. Umrichter (10) nach einem der Ansprüche 1 bis 3, **dadurch gekennzeichnet, dass** der erste und/oder zweite Kühlkörper (22, 24) mittelbar oder unmittelbar miteinander thermisch leitend verbunden sind.

5. Umrichter (10) nach einem der Ansprüche 1 bis 4, **dadurch gekennzeichnet, dass** die Kühlkanäle hydraulisch miteinander verbunden sind oder hydraulisch separat ausgebildet sind.

6. Umrichter (10) nach einem der Ansprüche 1 bis 5, **dadurch gekennzeichnet, dass** zwischen dem ersten und zweiten Kühlkörper (22, 24) ein Zwischenraum (23) ausgebildet ist, der zu einem Entwärmen einer Umgebungsluft im Innenraum eines Umrichterschranks (50) luftdurchströmbar ist.

7. Umrichter (10) nach Anspruch 6, **dadurch gekennzeichnet, dass** der Umrichter (10) einen Lüfter (30) aufweist, der zu einem Anströmen des Zwischenraums (23) angeordnet ist.

8. Umrichter (10) nach einem der Ansprüche 1 bis 7, **dadurch gekennzeichnet, dass** die Kühlfinnen (28) jeweils mit dem ersten und/oder zweiten Kühlkörper (22, 24) verbunden sind.

9. Umrichter (10) nach einem der Ansprüche 1 bis 8, **dadurch gekennzeichnet, dass** die Kühlfinnen (28) als mechanische Stützen zwischen den Kühlkörpern (22, 24) dienen.

10. Umrichter (10) nach einem der Ansprüche 1 bis 9, **dadurch gekennzeichnet, dass** die Kühlfinnen (28) mit dem ersten und zweiten Kühlkörper (22, 24) thermisch leitend verbunden sind und sich durch den luftdurchströmbaren Zwischenraum (23) erstrecken.

11. Umrichter (10) nach einem der Ansprüche 1 bis 10, **dadurch gekennzeichnet, dass** die Zwischenkreisverschienung (16) ungestuft ausgebildet ist.

12. Umrichter (10) nach einem der Ansprüche 1 bis 11, **dadurch gekennzeichnet, dass** der Umrichter (10) eine Stromschiene (18) aufweist, die auf einer den Halbleiterschaltern (12) abgewandten Seite (21) des ersten Kühlkörpers (22) und/oder dem zumindest einen Energiespeicher (14) abgewandten Seite (29) des zweiten Kühlkörper (24) befestigt ist.

13. Umrichter (10) nach einem der Ansprüche 1 bis 12, **dadurch gekennzeichnet, dass** eine Halbbrücke, zu der die Halbleiterschalter (12) gehören, frei von Snubber-Kondensatoren ausgebildet ist.

14. Umrichter (10) nach einem der Ansprüche 1 bis 13, **dadurch gekennzeichnet, dass** der zweite Kühlkörper (24) in einer Lagenrichtung (27) den zumindest einen Energiespeicher (14) einseitig überragt.

15. Umrichter (10) nach einem der Ansprüche 1 bis 14, **dadurch gekennzeichnet, dass** der erste und/oder zweite Kühlkörper (22, 24) durch Additive Fertigung hergestellt ist.

16. Umrichterschrank (50), umfassend Wandungen (52), innerhalb derer zumindest ein Umrichter (10) angeordnet ist, **dadurch gekennzeichnet, dass** der Umrichter (10) nach einem der Ansprüche 1 bis 15 ausgebildet ist.

## Claims

1. Converter (10), comprising a plurality of semiconductor switches (12) and at least one energy storage device (14), a DC-link busbar system (16), a first heat sink (22) for dissipating heat from the semiconductor switch (12) and a second heat sink (24) for dissipating heat from the at least one energy storage device (14), wherein the first and/or second heat sinks (22, 24) are liquid-cooled, wherein the first and second heat sinks (22, 24) are arranged offset from one another in a direction of assembly (25) of the converter (10) for dissipating heat from ambient air in an environment (55) of the converter (10), wherein the direction of assembly corresponds to the direction in which at least one semiconductor switch (12) is mounted on the first heat sink (22) and/or the at least one energy storage device (14) is mounted on the second heat sink (24), **characterised in that** the first heat sink (22) is connected to the second heat sink (24) via cooling fins (28).

2. Converter (10) according to claim 1, **characterised in that** the first and second heat sinks (22, 24) are flat in design at least in the area of the semiconductor switch (12) or the at least one energy storage device (14).

3. Converter (10) according to claim 1 or 2, **characterised in that** the first and second heat sinks (22, 24) are arranged parallel to one another.

4. Converter (10) according to one of claims 1 to 3, **characterised in that** the first and/or second heat sinks (22, 24) are thermally connected to one other directly or indirectly.

5. Converter (10) according to one of claims 1 to 4, **characterised in that** the cooling channels are hydraulically connected to one another or are hydraulically separated.

6. Converter (10) according to one of claims 1 to 5, **characterised in that** an intermediate space (23) is formed between the first and second heat sinks (22, 24) through which air can flow to dissipate heat from the ambient air in the interior space of a converter cabinet (50).

7. Converter (10) according to claim 6, **characterised in that** the converter (10) has a fan (30) which is arranged to blow air into the intermediate space (23).

8. Converter (10) according to one of claims 1 to 7, **characterised in that** the cooling fins (28) are each connected to the first and/or second heat sink (22, 24).

9. Converter (10) according to one of claims 1 to 8, **characterised in that** the cooling fins serve as mechanical supports between the cooling fins (22, 24).

10. Converter (10) according to one of claims 1 to 9, **characterised in that** the cooling fins (28) are connected to the first and second heat sink (22, 24) in a thermally conductive manner and extend through the intermediate space (23) through which air can flow.

11. Converter (10) according to one of claims 1 to 10, **characterised in that** the DC-link busbar system (16) is designed to be stepless.

12. Converter (10) according to one of claims 1 to 11, **characterised in that** the converter (10) has a conductor rail (18) which is attached to a side (21) of the first heat sink (22) facing away from the semiconductor switches (12) and/or to a side (29) of the second heat sink (24) facing away from the at least one energy storage device (14).

13. Converter (10) according to one of claims 1 to 12, **characterised in that** a half-bridge to which the semiconductor switches (12) belong is designed without snubber capacitors.

14. Converter (10) according to one of claims 1 to 13, **characterised in that** the second heat sink (24) protrudes beyond the at least one energy storage device (14) on one side in a layer direction (27).

15. Converter (10) according to one of claims 1 to 14, **characterised in that** the first and/or second heat sink (22, 24) is produced by means of additive manufacturing.

16. Converter cabinet (50), comprising walls (52) within which at least one converter (10) is arranged, **characterised in that** the converter (10) is designed according to one of claims 1 to 15.

## Revendications

1. Convertisseur (10), comprenant une pluralité d'interrupteurs (12) à semiconducteur et au moins un accumulateur (14) d'énergie, une barre (16) de circuit intermédiaire, un premier puits (22) de chaleur pour une dissipation de la chaleur des interrupteurs (12) à semiconducteur et un deuxième puits (24) de chaleur pour une dissipation de la chaleur du au moins un accumulateur (14) d'énergie, dans lequel le premier et/ou le deuxième puits (22, 24) de chaleur sont refroidis par du liquide, dans lequel le premier et le deuxième puits (22, 24) de chaleur sont, pour une dissipation de la chaleur de l'air ambiant dans un environnement (55) du convertisseur (10), disposés de manière décalée l'un par rapport à l'autre suivant une direction (25) de montage du convertisseur (10), dans lequel la direction de montage correspond à la direction suivant laquelle le au moins un interrupteur (12) à semiconducteur est mis sur le premier puits (22) de chaleur et/ou le au moins un accumulateur (14) d'énergie est mis sur le deuxième puits (24) de chaleur, **caractérisé en ce que** le premier puits (22) de chaleur est relié au deuxième puits (24) de chaleur par des ailettes (28) de refroidissement.

2. Convertisseur (10) suivant la revendication 1, **caractérisé en ce que** le premier et le deuxième puits (22, 24) de chaleur sont de constitution plane, au moins dans la partie des interrupteurs (12) à semiconducteur ou du au moins un accumulateur (14) d'énergie.

3. Convertisseur (10) suivant la revendication 1 ou 2, **caractérisé en ce que** le premier et le deuxième puits (22, 24) de chaleur sont disposés en étant parallèles entre eux.

4. Convertisseur (10) suivant l'une des revendications 1 à 3, **caractérisé en ce que** le premier et/ou le deuxième puits (22, 24) de chaleur sont reliés entre eux, de manière à conduire la chaleur indirectement ou directement.

5. Convertisseur (10) suivant l'une des revendications 1 à 4, **caractérisé en ce que** les conduits de refroidissement communiquent entre eux hydrauliquement ou sont constitués hydrauliquement de manière distincte.

6. Convertisseur (10) suivant l'une des revendications 1 à 5, **caractérisé en ce que**, entre le premier et le deuxième puits (22, 24) de chaleur, est constitué un espace (23) intermédiaire, dans lequel de l'air peut passer pour une dissipation de la chaleur d'un air ambiant dans l'espace intermédiaire d'une armoire (50) de convertisseur.

7. Convertisseur (10) suivant la revendication 6, **caractérisé en ce que** le convertisseur (10) a un ventilateur (30), qui est disposé pour un afflux dans l'espace (23) intermédiaire.

8. Convertisseur (10) suivant l'une des revendications 1 à 7, **caractérisé en ce que** les ailettes (28) de refroidissement sont reliées respectivement au premier et/ou au deuxième puits (22, 24) de chaleur.

9. Convertisseur (10) suivant l'une des revendications 1 à 8, **caractérisé en ce que** les ailettes (28) de refroidissement servent d'appui mécanique entre les puits (22, 24) de chaleur.

10. Convertisseur (10) suivant l'une des revendications 1 à 9, **caractérisé en ce que** les ailettes (28) de refroidissement sont reliées d'une manière à conduire la chaleur au premier et au deuxième puits (22, 24) de chaleur et s'étendent dans l'espace (23) intermédiaire, dans lequel peut passer de l'air.

11. Convertisseur (10) suivant l'une des revendications 1 à 10, **caractérisé en ce que** la barre (16) de circuit intermédiaire est constituée sans gradin.

12. Convertisseur (10) suivant l'une des revendications 1 à 11, **caractérisé en ce que** le convertisseur (10) a un rail (18) de courant, qui est fixé sur une face (21) du premier puits (22) de chaleur non tournée vers les interrupteurs (12) à semiconducteur et/ou sur la face (29) du deuxième puits (24) de chaleur non tournée vers le au moins un accumulateur (14) d'énergie.

13. Convertisseur (10) suivant l'une des revendications 1 à 12, **caractérisé en ce qu'**un demi-pont, auquel les interrupteurs (12) à semiconducteur appartiennent, est constitué sans condensateur snubber.

14. Convertisseur (10) suivant l'une des revendications 1 à 13, **caractérisé en ce que** le deuxième puits (24) de chaleur fait saillie d'un côté dans une position (27) de montage du au moins un accumulateur (14) d'énergie.

15. Convertisseur (10) suivant l'une des revendications 1 à 14, **caractérisé en ce que** le premier et/ou le deuxième puits (22, 24) de chaleur sont fabriqués par fabrication additive.

16. Armoire (50) de convertisseur, comprenant les parois (52), à l'intérieur desquelles est disposé au moins un convertisseur (10), **caractérisé en ce que** le convertisseur (10) est constitué suivant l'une des revendications 1 à 15.
